# EUROPÄISCHE PATENTSCHRIFT

(11) **EP 3 367 569 B1**
(45) Veröffentlichungstag und Bekanntmachung des Hinweises auf die Patenterteilung: **14.09.2022**
(21) Anmeldenummer: 17157287.8
(22) Anmeldetag: 22.02.2017
(51) Int. Cl.: H03K 17/95, G07C 9/00

(54) **SICHERHEITSSCHALTER**
SAFETY SWITCH
COMMUTATEUR DE SÉCURITÉ

(43) Veröffentlichungstag der Anmeldung: 29.08.2018
(73) Patentinhaber: EUCHNER GmbH + Co. KG, 70771 Leinfelden-Echterdingen (DE)
(72) Erfinder: Hahn, Frederic, 71065 Sindelfingen (DE); Zeiler, Gerd, 70771 Leinfelden-Echterdingen (DE)
(74) Vertreter: Ruckh, Rainer Gerhard

(56) Entgegenhaltungen:
- EP-A2- 0 111 753
- WO-A1-2008/031367
- DE-U1-202010 006 043
- N/a: "Redundanz (Technik)", WIKIPEDIA, 20 February 2017 (2017-02-20), pages 1-4, XP055912983, INTERNET Retrieved from the Internet: URL:https://de.wikipedia.org/w/index.php?t itle=Redundanz_(Technik)&oldid=162831282 [retrieved on 2022-04-14]

## Beschreibung

Die Erfindung betrifft einen Sicherheitsschalter gemäß dem Oberbegriff des Anspruchs 1.

Derartige Sicherheitsschalter werden im Bereich der Sicherheitstechnik eingesetzt, wobei diese insbesondere zur Gefahrenbereichsüberwachung an Maschinen und Anlagen eingesetzt werden.

Der Sicherheitsschalter generiert entsprechend seiner Überwachungsfunktion ein Schaltsignal, das an eine Steuerung ausgegeben wird, mit der zum Beispiel eine zu überwachende Maschine gesteuert wird. Wird mit dem Sicherheitsschalter ein gefahrloser Zustand detektiert, insbesondere, dass eine zu überwachende Tür geschlossen ist, wird ein Schaltsignal mit dem Schaltzustand "eingeschalteter Zustand" entsprechend einer aktiven Sicherheitsbedingung, das heißt einem Freigabesignal generiert. Empfängt die Steuerung vom Sicherheitsschalter dieses Freigabesignal, kann die Steuerung die Maschine in Betrieb nehmen beziehungsweise in Betrieb lassen. Wird mit dem Sicherheitsschalter jedoch ein gefahrbringender Zustand detektiert, zum Beispiel eine offene Tür registriert, generiert dieser ein Schaltsignal mit dem Schaltzustand "ausgeschalteter Zustand", entsprechend einer nicht aktiven Sicherheitsbedingung. In diesem Fall schaltet die Steuerung zur Vermeidung gefahrbringender Zustände die Maschine aus.

Bekannte Sicherheitsschalter weisen einen Lesekopf und einen relativ zum Lesekopf beweglichen Betätiger auf, wobei am Betätiger ein Transponder vorgesehen ist. Für den Fall, dass mit dem Sicherheitsschalter eine Tür, insbesondere eine Schutztür als Zugang zu einem Gefahrenbereich überwacht wird, ist typischerweise der Betätiger an der Tür angeordnet. Der Lesekopf befindet sich dann an einem die Tür umgebenden Rahmen. Mit dem so ausgebildeten Sicherheitsschalter wird ein einem gefahrlosen Zustand entsprechendes Schaltsignal generiert, wenn der Lesekopf vom Transponder generierte kodierte Signale empfängt. Bei einer Türüberwachung ist dies dann der Fall, wenn die Tür geschlossen ist und dadurch der Transponder in geringem Abstand zum Lesekopf liegt. Weiterhin wird mit dem so ausgebildeten Sicherheitsschalter ein einem gefahrbringenden Zustand entsprechendes Schaltsignal generiert, wenn der Lesekopf keine Signale des Transponders empfängt. Bei einer Türüberwachung ist dies dann der Fall, wenn die Tür offen ist und dadurch der Transponder in einem großen Abstand zum Lesekopf ist.

Die EP 0 111 753 A2 betrifft eine Anordnung zum Identifizieren eines Objektes und zum Ermitteln des Abstandes, beispielsweise eines Fahrzeugs, Maschinenteils oder eines Ortes auf einer Fahrstrecke. Eine Identifizierungseinrichtung strahlt über eine Sendeantenne Energie ab. Ein Kodeträger auf dem Objekt erhält über eine Empfangsantenne diese Energie und setzt sie um in Betriebsenergie. Der Kodeträger aktiviert einen Kodespeicher. Der Kode wird ausgelesen und die Empfangsantenne dadurch beschaltet. Diese Beschaltung führt an der Sendeantenne der Identifizierungseinrichtung zu einer Feldveränderung und damit zu einer Modulation. Die Modulation kann herausgefiltert, verstärkt und ausgewertet werden. Der Grad der Modulation ist ein Maß für den Abstand zwischen Identifizierungseinrichtung und Kodeträger.

Die WO 2008/031367 A1 betrifft ein Verfahren zur Schaltbereichskontrolle eines berührungslosen Schaltsystems mit wenigstens einem Sensor und wenigstens einem Signalgeber, wobei der Signalgeber Daten zum Sensor sendet. Eine äußerst flexible und praktikable Schaltbereichskontrolle wird dadurch erreicht, indem eine Änderung mindestens eines Systemparameters des Schaltsystems mindestens eine erste Information zur Position des Signalgebers ableitet. Das Verfahren stellt eine Möglichkeit der Schaltbereichskontrolle dar, die Optionen für die Definition und Einteilung der Einschalt-, Ausschalt- und Hysteresebereiche aufweist.

Die DE 20 2010 006 043 U1 betrifft einen Näherungssensor zum Bestimmen eines Abstands, der wenigstens ein Lesegerät und wenigstens einen Transponder aufweist, wobei das Lesegerät zum Senden und Empfangen von Signalen sowie zum Auswerten der empfangenen Signale vorgesehen ist. Der Transponder wird durch die von Lesegerät gesendeten Signale aktiviert, wobei der Transponder im aktivierten Zustand selbst Signale aussendet oder vom Lesegerät gesendete Signale verändert. Das vom Transponder gesendete Signal weist bevorzugt eine Kennung auf, durch die der Transponder identifiziert wird. Das Lesegerät und der Transponder sind elektromagnetisch, induktiv, kapazitiv und/oder optisch miteinander gekoppelt. Die Intensität der Kopplung zwischen dem Lesegerät und dem Transponder wird zum Bestimmen des Abstandes zwischen dem Lesegerät und dem Transponder verwendet.

Der Erfindung liegt die Aufgabe zugrunde, einen Sicherheitsschalter mit erhöhter Funktionalität bereitzustellen.

Zur Lösung dieser Aufgabe sind die Merkmale des Anspruchs 1 vorgesehen. Vorteilhafte Ausführungsformen und zweckmäßige Weiterbildungen sind in den abhängigen Ansprüchen beschrieben.

Die Erfindung betrifft einen Sicherheitsschalter mit einem Lesekopf und einem relativ zum Lesekopf beweglichen, einen Transponder aufweisenden Betätiger. Mittels des Lesekopfs sind kodierte Signale des Transponders erfassbar. Als Erfassungsmittel zur Erfassung von kodierten Signalen weist der Lesekopf einen von einer Rechnereinheit gesteuerten Schwingkreis auf, wobei durch eine Amplitudenbewertung der mit dem Schwingkreis erfassten Signale des Transponders der Abstand zwischen Betätiger und Lesekopf ermittelt wird. In Abhängigkeit der so ermittelten Abstandssignale werden Steuersignale generiert. In der Rechnereinheit sind ein Einschaltabstand und ein Ausschaltabstand, mit welchen die ermittelten Abstandssignale verglichen werden, als konfigurierbare Größen vorgegeben. In der Rechnereinheit wird ein Einschaltsteuersignal generiert, wenn der Abstandswert des Abstandssignals kleiner als der Einschaltabstand ist und wenn der Code des Transponders erkannt ist, wobei durch das Einschaltsteuersignal das Inbetriebsetzen der Maschine oder Anlage erfolgt. Ein Ausschaltsteuersignal wird generiert, wenn der Abstandswert des Abstandssignals größer als der Ausschaltabstand ist oder wenn der Code des Transponders nicht erkannt ist, wobei durch das Ausschaltsteuersignal die Maschine oder Anlage stillgesetzt ist. In der Rechnereinheit werden Kontrollsignale für den Schwingkreis generiert, die zur Überwachung der Versorgungsspannung des Schwingkreises dienen, um Änderungen in diesem diagnostizieren zu können.

Ein wesentlicher Vorteil des erfindungsgemäßen Sicherheitsschalters besteht darin, dass die mit diesem generierten Steuersignale in Abhängigkeit der ermittelten Abstandssignale gezielt vorgegeben und eingestellt werden können. Dadurch ergibt sich eine wesentlich erhöhte Funktionalität gegenüber bekannten Sicherheitsschaltern, da dort die Steuersignale durch das Erkennen oder Nichterkennen des Codes der Transpondersignale im Lesekopf fest vorgegeben sind.

Wesentlich hierbei ist, dass die Amplitudenbewertung der Signale des Transponders ein eindeutiges Maß für den Abstand des Transponders zum Betätiger liefert. Dabei ist die Amplitude des Abstandssignals umso kleiner je größer der Abstand ist. Der Abstand zwischen Betätiger und Lesekopf liefert eine zuverlässige Information darüber, ob ein gefahrbringender Zustand vorliegt oder nicht. Insbesondere kann anhand des Abstandssignals ermittelt werden, ob eine zu überwachende Tür geschlossen ist oder nicht. Damit könnten prinzipiell die Steuersignale allein aus den ermittelten Abstandssignalen abgeleitet werden. Besonders vorteilhaft werden bei der Generierung der Steuersignale jedoch nicht nur die Abstandssignale herangezogen, sondern auch die Erkennung des Codes des Transponders, wodurch die Funktionssicherheit des Sicherheitsschalters erheblich erhöht wird.

Für den Fall, dass ein Sicherheitsschalter allein für eine Gefahrenbereichsüberwachung eingesetzt, können die im Sicherheitsschalter generierten Steuersignale Schaltsignale bilden, die vom Sicherheitsschalter direkt nach außen gegeben werden und in eine Steuerung eingelesen werden, die damit eine gefahrbringende Maschine oder Anlage steuert, insbesondere stilllegt oder in Betrieb setzt.

Für den Fall, dass mehrere Sicherheitsschalter für eine Gefahrenbereichsüberwachung eingesetzt werden und beispielsweise eine Reihenschaltung bilden, werden die Steuersignale aller Sicherheitsschalter verknüpf oder verrechnet, wobei dann dieses Schaltsignal an die Steuerung ausgegeben wird, welche dann die gefahrbringende Maschine oder Anlage steuert.

Eine Konfiguration von Steuersignalen erfolgt erfindungsgemäß dadurch , dass in der Rechnereinheit ein Einschaltabstand und ein Ausschaltabstand, mit welchen die ermittelten Abstandssignale verglichen werden, als konfigurierbare Größen vorgegeben sind.

Wenn das Abstandssignal den Einschaltabstand unterschreitet, liegt ein Kriterium für einen gefahrlosen Zustand vor, so dass dementsprechend als Steuersignal ein Einschaltsteuersignal generiert werden kann, das ein Inbetriebsetzen einer gefahrbringenden Maschine oder Anlage ermöglicht. Wenn das Abstandssignal den Ausschaltabstand überschreitet, liegt dagegen ein Kriterium für einen gefahrbringenden Zustand vor, so dass dementsprechend als Steuersignal ein Ausschaltsteuersignal generiert werden kann, durch das die gefahrbringende Maschine oder Anlage stillgesetzt werden kann.

Besonders vorteilhaft wird in der Rechnereinheit ein Einschaltsteuersignal generiert, wenn der Abstandswert des Abstandssignals kleiner als der Einschaltabstand ist, und wenn der Code des Transponders erkannt ist.

Weiterhin wird in der Rechnereinheit ein Ausschaltsteuersignal generiert, wenn der Abstandswert des Abstandssignals größer als der Ausschaltabstand ist, oder wenn der Code des Transponders nicht erkannt ist.

Dadurch wird eine besonders hohe Sicherheit und Zuverlässigkeit der Überwachungsfunktion des Sicherheitsschalters erhalten. Dies wird besonders dadurch erreicht, dass ein Einschaltsteuersignal für ein Inbetriebsetzen einer gefahrbringenden Maschine nur dann generiert wird, wenn zwei Sicherheitsbedingungen in einer UND-Verknüpfung realisiert sind, nämlich wenn der ermittelte Abstand kleiner als der Einschaltsteuersignal ist und wenn der Code des Transponders erkannt wird.

Durch die Konfigurierbarkeit des Einschaltabstands und des Ausschaltabstands können im Produktionsprozess Fertigungstoleranzen ausgeglichen werden, so dass die Sicherheitsschalter unabhängig von derartigen Fertigungstoleranzen sind.

Weiterhin können die Einschaltabstände und Ausschaltabstände auch entsprechend kundenspezifischer Anforderungen konfiguriert werden. Damit können mit nur einem Sicherheitsschalter verschiedene Applikationen ohne jegliche Hardware- oder Softwareänderungen realisiert werden.

Schließlich kann durch eine geeignete Konfiguration der Ausschaltabstand so konfiguriert werden, dass dieser weitgehend mit einem sich aus einer Fehlerbetrachtung des Sicherheitsschalters ergebenden sicheren Ausschaltabstand übereinstimmt, was hinsichtlich der sicherheitstechnischen Anforderungen vorteilhaft ist.

Mit dem Lesekopf des Sicherheitsschalters wird, wenn sich der Betätiger in einem hinreichend kleinen Abstand zu diesem befindet, der Code des Transponders erfasst. Dabei weisen die Signale des Transponders eine einem Code entsprechende Amplitudenmodulation auf.

Vorteilhaft wird die Amplitudenmodulation der Transpondersignale auch zur Amplitudenbewertung für die Abstandsbestimmung genutzt. Dabei erfolgt die Amplitudenbewertung des Signals des Transponders derart, dass dessen Modulationsgrad bestimmt wird.

Der Modulationsgrad ist als Differenz aufeinanderfolgender Maxima und Minima des amplitudenmodulierten Signals definiert.

Gemäß einer vorteilhaften Ausgestaltung der Erfindung wird in der Rechnereinheit ein Anregungssignal zur Anregung des Schwingkreises generiert.

Durch das Anregungssignal wird mittels einer Anregungsspule ein elektromagnetisches Feld generiert, welches durch das Signal eines im Einflussbereich des Schwingkreises befindlichen Transponders beeinflusst ist.

Die Rechnereinheit übernimmt somit eine zentrale Steuerungsfunktion derart, dass mit dieser der Schwingkreis zum Einlesen der Signale des Transponders angesteuert wird. Weiterhin erfolgt auch die Signalauswertung in der Rechnereinheit, wobei für die Codeerkennung einerseits und die Abstandsermittlung andererseits vorteilhaft getrennte Auswertekanäle in der Rechnereinheit vorgesehen sind.

Erfindungsgemäß werden in der Rechnereinheit Kontrollsignale für den Schwingkreis generiert.

Dabei dienen die Kontrollsignale zur Überwachung der Versorgungsspannung des Schwingkreises um Änderungen in diesem diagnostizieren zu können. Generell wird mit den Kontrollsignalen ein reproduzierbares, kontrolliertes Verhalten des Schwingkreises sichergestellt, so dass Verfälschungen der Messsignale durch Änderungen des Schwingkreises weitgehend ausgeschlossen werden können.

Zur Erfüllung der Anforderungen für einen Einsatz im Bereich der Sicherheitstechnik weist die Rechnereinheit einen redundanten Aufbau auf.

Insbesondere weist die Rechnereinheit zwei Microcontroller oder zwei ASIC auf. Generell kann die Rechnereinheit auch eine andere Anzahl von Microcontrollern oder ASIC aufweisen. Schließlich kann die Rechnereinheit auch einen einkanaligen Aufbau aufweisen.

Die Steuerungsfunktion und die Signal-Auswertung sind demzufolge in der Software der Microcontroller realisiert.

Alternativ können auch hardwareorientierte Realisierungen in Form von ASICs oder dergleichen vorgesehen sein.

Gemäß einer vorteilhaften Ausgestaltung weist der Sicherheitsschalter eine Zuhaltung auf.

Mit einer solchen Zuhaltung wird der Betätiger in einer Schließstellung am Lesekopf gesichert, das heißt gehalten. Die Zuhaltung kann als mechanische Einheit oder auch als elektrische Einheit mit einem Elektromagneten oder dergleichen ausgebildet sein.

Die Erfindung wird im Folgenden anhand der Zeichnungen erläutert. Es zeigen:
- Figur 1:: Schematische Darstellung eines Ausführungsbeispiels des erfindungsgemäßen Sicherheitsschalters.
- Figur 2:: Diagramm der in der Rechnereinheit des Sicherheitsschalters gemäß Figur 1 implementierten Signalauswertung.

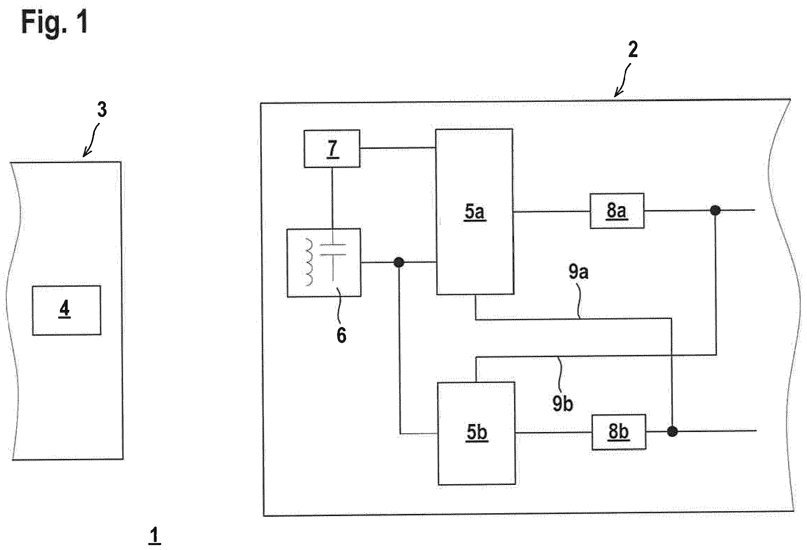

Figur 1 zeigt schematisch den Aufbau des erfindungsgemäßen Sicherheitsschalters 1. Der Sicherheitsschalter 1 kann insbesondere zur Überwachung einer Tür als Zugang zu einer Maschine oder Anlage, von der Gefährdungen von Personen ausgehen können, eingesetzt werden.

Der Sicherheitsschalter 1 weist einen Lesekopf 2 und einen Betätiger 3 auf. Bei einer Türüberwachung befindet sich der Betätiger 3 typischerweise an der beweglichen Tür, während der Lesekopf 2 stationär an einem Rahmen oder dergleichen angeordnet ist. Wenn die Tür in ihre Schließstellung verfahren ist, ist der Betätiger 3 in einer nicht dargestellten Aufnahme des Lesekopfs 2 gelagert und ist dort vorteilhaft mit einer ebenfalls nicht dargestellten Zuhaltung festgehalten.

Wie aus Figur 1 ersichtlich, weist der Betätiger 3 einen Transponder 4 auf. Der Lesekopf 2 weist eine redundante Rechnereinheit mit zwei Microcontrollern 5a, 5b auf. Weiterhin weist der Lesekopf 2 einen Schwingkreis 6 auf, der über eine Treiberschaltung 7 von einem der Microcontroller 5a angesteuert wird. Mit dem Schwingkreis 6 sind Signale des Transponders 4 erfassbar. Die dadurch generierten Messsignale des Schwingkreises 6 werden den beiden Microcontrollern 5a, 5b vorzugsweise über Entkopplungsschaltungen, die negative Pulse in den Messsignalen eliminieren, zugeführt. Abhängig von den Messsignalen des Schwingkreises 6 werden in den Microcontrollern 5a, 5b Steuersignale, im vorliegenden Fall Schaltsignale, generiert, die auf Ausgänge 8a, 8b geführt sind. Die Schaltsignale an den Ausgängen 8a, 8b werden einer nicht dargestellten Steuerung zugeführt, mit welcher die zu überwachende Maschine oder Anlage gesteuert wird. Die Schaltsignale, die über einen Microcontroller 5a, 5b an einen Ausgang 8a, 8b ausgegeben werden, werden über jeweils eine Rückleseleitung 9a, 9b in den anderen Microcontroller 5b, 5a zur Funktionsüberprüfung dieser Einheiten rückgelesen.

Die Schaltsignale sind derart beschaffen, dass mit diesen der Betrieb der zu überwachenden Maschine oder Anlage nur dann freigegeben wird, wenn kein gefahrbringender Zustand vorliegt, welcher im vorliegenden Fall dann gegeben ist, wenn die Tür geschlossen und verriegelt ist. Ansonsten wird durch die Schaltsignale die Maschine oder Anlage stillgesetzt.

Die Funktionsweise des Sicherheitsschalters 1 ist derart, dass im Microcontroller 5a ein Ausgangssignal, insbesondere ein pulsweitenmoduliertes Signal, über die Treiberschaltung 7 an den Schwingkreis 6 ausgegeben wird. Durch den so angeregten Schwingkreis 6 wird in einer Anregungsspule des Schwingkreises 6 ein elektromagnetisches Feld erzeugt. Der Betrag des elektromagnetischen Felds klingt im Nahfeld umgekehrt proportional zum Quadrat des Abstands zum Schwingkreis 6 ab. Befindet sich der Transponder 4 im Einflussbereich des Schwingkreises 6, wird durch das elektromagnetische Feld der Anregungsspule Energie in eine Spule des Transponders 4 eingekoppelt. Reicht die Energie im Transponder 4 aus, sendet er einen abgespeicherten Code mittels der Spule an den Lesekopf 2. Die Aussendung des entsprechend dem Code amplitudenmodulierten Signals erfolgt durch eine Lastmodulation. Bei dieser Lastmodulation wird dem elektromagnetischen Feld durch einen Kurzschluss Energie entzogen. Diese Änderung der Energie des elektromagnetischen Felds ist in der Anregungsspule des Schwingkreises 6 sichtbar, das heißt es wird das entsprechend dem Code des Transponders 4 amplitudenmodulierte Signal im Schwingkreis 6 registriert. Die Feldänderung ist direkt abhängig vom Abstand des Lesekopfs 2 zum Betätiger 3, das heißt das amplitudenmodulierte Signal des Transponders 4, das im Schwingkreis 6 registriert wird, liefert ein direktes Maß für den Abstand zwischen Lesekopf 2 und Transponder 4.

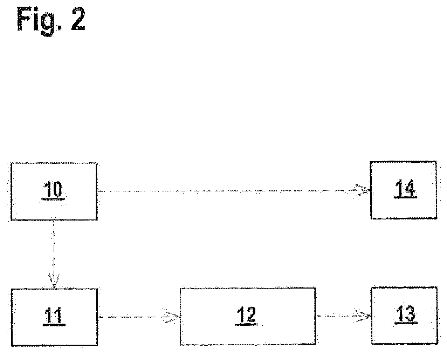

In den Microcontrollern 5a, 5b erfolgt anhand der im Schwingkreis 6 registrierten Signale sowohl eine Erkennung des Codes des Transponders 4 als auch eine Abstandsbestimmung. Die in der Software der Microcontroller 5a, 5b hierzu vorgesehene Auswertung ist schematisch in Figur 2 dargestellt. Das Einlesen der Signale des Schwingkreises 6 übernimmt eine Datenaufnahme 10. Ein erster Auswertungszweig umfasst einen Filter 11 zur Signalfilterung, eine Dekodiereinheit 12 zur Dekodierung des Signals des Transponders 4 und eine Codebewertungseinheit 13 zur Bewertung des Codes.

Ein zweiter Auswertungszweig umfasst eine Abstandsermittlungseinheit 14. Dort wird durch eine Amplitudenbewertung der Signale des Transponders 4 der Abstand des Betätigers 3 zum Lesekopf 2 bestimmt.

In der Abstandsermittlungseinheit 14 sind zur Bewertung der Abstandsignale, die der Schwingkreis 6 liefert, als konfigurierbare Größen ein Einschaltabstand und ein Ausschaltabstand vorgegeben. Der Einschaltabstand und der Ausschaltabstand bilden Schwellwerte, mit denen die ermittelten Abstandssignale verglichen werden, wobei der Einschaltabstand kleiner ist als der Ausschaltabstand.

Abhängig von den Ergebnissen der Signalauswertungen in der Abstandsermittlungseinheit 14 und in der Codebewertungseinheit 13 werden in der Rechnereinheit Steuersignale generiert, die als Schaltsignale über die Ausgänge 8a, 8b an die Steuerung zur Ansteuerung der zu überwachenden Maschine oder Anlage ausgegeben werden.

Dabei wird in der Rechnereinheit als Steuersignal ein Einschaltsteuersignal generiert, wenn der Abstandswert des Abstandssignals kleiner als der Einschaltabstand ist und gleichzeitig der Code des Transponders 4 in der Codebewertungseinheit 13 erkannt wird. Bei der Erfüllung dieser Bedingungen ist sicher gewährleistet, dass die Tür geschlossen ist und damit kein gefahrbringender Zustand vorliegt. Mit dem Einschaltsteuersignal wird daher der Betrieb der zu überwachenden Maschine oder Anlage freigegeben.

In der Rechnereinheit wird ein Ausschaltsteuersignal generiert, wenn der Abstandwert des Abstandssignals größer als der Ausschaltabstand ist oder wenn der Code des Transponders 4 nicht erkannt wird. Da somit wenigstens eine der Bedingungen für einen gefahrlosen Zustand, das heißt dass die Tür geschlossen ist, nicht vorliegt, wird dies in der Rechnereinheit als gefahrbringender Zustand gewertet, so dass als Schaltsignal das Ausschaltsteuersignal an die Steuerung ausgegeben wird, mit der die zu überwachende Maschine oder Anlage außer Betrieb gesetzt ist.

### Bezugszeichenliste

- (1): Sicherheitsschalter
- (2): Lesekopf
- (3): Betätiger
- (4): Transponder
- (5a, 5b): Microcontroller
- (6): Schwingkreis
- (7): Treiberschaltung
- (8a, 8b): Ausgang
- (9a, 9b): Rückleseleitung
- (10): Datenaufnahme
- (11): Filter
- (12): Dekodiereinheit
- (13): Codebewertungseinheit
- (14): Abstandsermittlungseinheit

## Patentansprüche

1. Sicherheitsschalter (1) zur Gefahrenbereichsüberwachung einer Maschine oder Anlage mit einem Lesekopf (2) und einem relativ zum Lesekopf (2) beweglichen, einen Transponder (4) aufweisenden Betätiger (3), wobei mittels des Lesekopfs (2) kodierte Signale des Transponders (4) erfassbar sind, wobei als Erfassungsmittel zur Erfassung von kodierten Signalen der Lesekopf (2) einen von einer Rechnereinheit gesteuerten Schwingkreis (6) aufweist, wobei durch eine Amplitudenbewertung der mit dem Schwingkreis (6) erfassten Signale des Transponders (4) der Abstand zwischen Betätiger (3) und Lesekopf (2) ermittelt wird, und wobei in Abhängigkeit der so ermittelten Abstandssignale Steuersignale generiert werden, **dadurch gekennzeichnet, dass** in der Rechnereinheit ein Einschaltabstand und ein Ausschaltabstand, mit welchen die ermittelten Abstandssignale verglichen werden, als konfigurierbare Größen vorgegeben sind, in der Rechnereinheit ein Einschaltsteuersignal generiert wird, wenn der Abstandswert des Abstandssignals kleiner als der Einschaltabstand ist und wenn der Code des Transponders (4) erkannt ist, wobei durch das Einschaltsteuersignal das Inbetriebsetzen der Maschine oder Anlage erfolgt, und dass in der Rechnereinheit ein Ausschaltsteuersignal generiert wird, wenn der Abstandswert des Abstandssignals größer als der Ausschaltabstand ist oder wenn der Code des Transponders (4) nicht erkannt ist, wobei durch das Ausschaltsteuersignal die Maschine oder Anlage stillgesetzt ist, und dass in der Rechnereinheit Kontrollsignale für den Schwingkreis (6) generiert werden, wobei die Kontrollsignale zur Überwachung der Versorgungsspannung des Schwingkreises dienen, um Änderungen in diesem diagnostizieren zu können.

2. Sicherheitsschalter nach Anspruch 1, **dadurch gekennzeichnet, dass** die Signale des Transponders (4) eine einem Code entsprechende Amplitudenmodulation aufweisen.

3. Sicherheitsschalter nach Anspruch 2, **dadurch gekennzeichnet, dass** die Amplitudenbewertung des Signals des Transponders (4) derart erfolgt, dass dessen Modulationsgrad bestimmt wird.

4. Sicherheitsschalter nach einem der Ansprüche 1 bis 3, **dadurch gekennzeichnet, dass** in der Rechnereinheit ein Anregungssignal zur Anregung des Schwingkreises (6) generiert wird.

5. Sicherheitsschalter nach Anspruch 4, **dadurch gekennzeichnet, dass** durch das Anregungssignal mittels einer Anregungsspule ein elektromagnetisches Feld generiert wird, welches durch das Signal eines im Einflussbereich des Schwingkreises (6) befindlichen Transponders (4) beeinflusst ist.

6. Sicherheitsschalter nach einem der Ansprüche 1 bis 5, **dadurch gekennzeichnet, dass** die im Schwingkreis (6) generierten Signale der Rechnereinheit über eine Entkopplungsschaltung zugeführt sind.

7. Sicherheitsschalter nach einem der Ansprüche 1 bis 5, **dadurch gekennzeichnet, dass** die Rechnereinheit einen redundanten Aufbau aufweist.

8. Sicherheitsschalter nach Anspruch 7, **dadurch gekennzeichnet, dass** die Rechnereinheit zwei Microcontroller (5a, 5b) oder zwei ASIC aufweist.

9. Sicherheitsschalter nach einem der Ansprüche 1 bis 8, **dadurch gekennzeichnet, dass** dieser eine Zuhaltung aufweist.

## Claims

1. Safety switch (1) for risk-region monitoring of a machine or plant, comprising a reader head (2) and an actuator (3), which is movable relative to the reader head (2) and comprises a transponder (4), wherein coded signals of the transponder (4) are detectable by means of the reader head (2), wherein as detecting means for detecting coded signals the reader head (2) comprises an oscillation circuit (6) controlled by a computer unit, wherein the distance between actuator (3) and reader head (2) is determined by amplitude evaluation of the signals, which are detected by the oscillation circuit (6), of the transponder (4) and wherein control signals are generated in dependence on the thus-determined distance signals, **characterised in that** a switch-on distance and a switch-off distance with which the determined distance signals are compared are predetermined as configurable variables in the computer unit, a switch-on control signal is generated in the computer unit if the distance value of the distance signal is smaller than the switch-on distance and if the code of the transponder (4) is recognised, wherein placing of the machine or plant in operation takes place through the switch-on control signal, and a switch-off control signal is generated in the computer unit if the distance value of the distance signal is greater than the switch-off distance or if the code of the transponder (4) is not recognised, wherein the machine or plant is stopped by the switch-off control signal, and check signals for the oscillation circuit (6) are generated in the computer unit, wherein the check signals serve for monitoring the supply voltage of the oscillation circuit so as to be able to diagnose changes therein.

2. Safety switch according to claim 1, **characterised in that** the signals of the transponder (4) comprise an amplitude modulation corresponding with a code.

3. Safety switch according to claim 2, **characterised in that** the amplitude evaluation of the signal of the transponder (4) is carried out in such a way that the degree of modulation thereof is determined.

4. Safety switch according to any one of claims 1 to 3, **characterised in that** an excitation signal for excitation of the oscillation circuit (6) is generated in the computer unit.

5. Safety switch according to claim 4, **characterised in that** an electromagnetic field which is influenced by the signal of a transponder (4) present in the range of influencing the oscillation circuit (6) is generated by the excitation signal by way of an excitation coil.

6. Safety switch according to any one of claims 1 to 5, **characterised in that** the signals, which are generated in the oscillation circuit (6), are supplied to the computer unit by way of a decoupling circuit.

7. Safety switch according to any one of claims 1 to 5, **characterised in that** the computer unit has a redundant construction.

8. Safety switch according to claim 7, **characterised in that** the computer unit comprises two microcontrollers (5a, 5b) or two ASIC.

9. Safety switch according to any one of claims 1 to 8, **characterised in that** this comprises a retaining means.

## Revendications

1. Interrupteur de sécurité (1) pour la surveillance d'une zone de danger d'une machine ou d'une installation, avec une tête de lecture (2) et un actionneur (3) mobile par rapport à la tête de lecture (2) et présentant un transpondeur (4), des signaux codés du transpondeur (4) pouvant être détectés au moyen de la tête de lecture (2), la tête de lecture (2) présentant comme moyen de détection pour la détection de signaux codés un circuit oscillant (6) commandé par une unité de calcul, la distance entre l'actionneur (3) et la tête de lecture (2) étant déterminée par une évaluation d'amplitude des signaux du transpondeur (4) détectés à l'aide du circuit oscillant (6), et des signaux de commande étant générés en fonction des signaux de distance ainsi déterminés,
**caractérisé en ce que**, dans l'unité de calcul, une distance d'activation et une distance de désactivation, auxquelles sont comparés les signaux de distance déterminés, sont prédéfinies en tant que grandeurs configurables, un signal de commande d'activation est généré dans l'unité de calcul lorsque la valeur de distance du signal de distance est inférieure à la distance d'activation et lorsque le code du transpondeur (4) est reconnu, la mise en service de la machine ou de l'installation étant effectuée par le signal de commande d'activation, et **en ce qu'**un signal de commande de désactivation est généré dans l'unité de calcul lorsque la valeur de distance du signal de distance est supérieure à la distance de désactivation ou lorsque le code du transpondeur (4) n'est pas reconnu, la machine ou l'installation étant mise à l'arrêt par le signal de commande de désactivation, et **en ce que** des signaux de contrôle pour le circuit oscillant (6) sont générés dans l'unité de calcul, les signaux de contrôle servant à surveiller la tension d'alimentation du circuit oscillant afin de pouvoir diagnostiquer des modifications dans celui-ci.

2. Interrupteur de sécurité selon la revendication 1, **caractérisé en ce que** les signaux du transpondeur (4) présentent une modulation d'amplitude correspondant à un code.

3. Interrupteur de sécurité selon la revendication 2, **caractérisé en ce que** l'évaluation d'amplitude du signal du transpondeur (4) est effectuée de manière à déterminer son degré de modulation.

4. Interrupteur de sécurité selon l'une des revendications 1 à 3, **caractérisé en ce qu'**un signal d'excitation pour exciter le circuit oscillant (6) est généré dans l'unité de calcul.

5. Interrupteur de sécurité selon la revendication 4, **caractérisé en ce qu'**un champ électromagnétique est généré par le signal d'excitation au moyen d'une bobine d'excitation, lequel champ est influencé par le signal d'un transpondeur (4) se trouvant dans la zone d'influence du circuit oscillant (6).

6. Interrupteur de sécurité selon l'une des revendications 1 à 5, **caractérisé en ce que** les signaux générés dans le circuit oscillant (6) sont amenés à l'unité de calcul par l'intermédiaire d'un circuit de découplage.

7. Interrupteur de sécurité selon l'une des revendications 1 à 5, **caractérisé en ce que** l'unité de calcul présente une structure redondante.

8. Interrupteur de sécurité selon la revendication 7, **caractérisé en ce que** l'unité de calcul présente deux microcontrôleurs (5a, 5b) ou deux ASIC.

9. Interrupteur de sécurité selon l'une des revendications 1 à 8, **caractérisé en ce qu'**il présente un interverrouillage.
